Europäisches Patentamt

(19) European Patent Office

Office européen des brevets

(11) EP 0 513 903 B1

(12) **EUROPÄISCHE PATENTSCHRIFT**

(45) Veröffentlichungstag und Bekanntmachung des Hinweises auf die Patenterteilung:
**11.09.1996 Patentblatt 1996/37**

(51) Int. Cl.$^6$: **C04B 35/46**, H01L 37/02

(21) Anmeldenummer: **92201296.8**

(22) Anmeldetag: **07.05.1992**

(54) **Pyroelektrisches Keramikmaterial und dessen Verwendung**

Pyroelectric ceramic materials and their use

Matériaux céramiques pyroélectriques et leur utilisation

(84) Benannte Vertragsstaaten:
**DE FR GB**

(30) Priorität: **16.05.1991 DE 4115949**

(43) Veröffentlichungstag der Anmeldung:
**19.11.1992 Patentblatt 1992/47**

(73) Patentinhaber:
 • **Philips Patentverwaltung GmbH**
  **22335 Hamburg (DE)**
  Benannte Vertragsstaaten:
  **DE**
 • **Philips Electronics N.V.**
  **5621 BA Eindhoven (NL)**
  Benannte Vertragsstaaten:
  **FR GB**

(72) Erfinder:
 • **Hennings, Detlev, Dr.**
  **W-2000 Hamburg 1 (DE)**
 • **Pankert, Joseph, Dr.**
  **W-2000 Hamburg 1 (DE)**

(74) Vertreter: **Kupfermann, Fritz-Joachim, Dipl.-Ing. et al**
 **Philips Patentverwaltung GmbH**
 **Postfach 10 51 49**
 **D-20035 Hamburg (DE)**

(56) Entgegenhaltungen:
 **FR-A- 2 073 941**

 • **AMERICAN SOCIETY BULLETIN, Band 66, Nr. 4, April 1987, Westerville, OH (US); Seiten 699-703; D.DAMJANOVIC et al.:"Anisotrophy in piezoelectric properties of modified lead titanate ceramics".**
 • **JAPANESE JOURNAL OF APPLIED PHYSICS, Band 11, Nr. 4, April 1972; Seiten 450-462; I. Ueda: "Effects of addivitvs on piezoelectric and related properties of PBTI03 ceramics".**
 • **JOURNAL OF MATERIALS SCIENCE, Band 23, 1988; Seiten 4463-4469; P. Duran et al.: "Large electromechanical anisotropic modified lead titanate ceramics".**
 • **JOURNAL OF MATERIALS SCIENCE LETTERS, Band 10, August 1991; Seiten 917-919; P. Duran et al.: "Effect of Mn0 additions on the sintering and piezoelectric properties os samarium-modified lead titanate ceramics".**
 • **IEEE TRANSACTIONS ON ULTRASONICS, FERROELECTRICS & FREQUENCY CONTROL, Band 36, Nr. 4, Juli 1989; Seiten 389-392; J.N. Kim et al.: "Temperature behaviour of dielectric and piezoelectric properties of samarium-doped lead titanate ceramics".**
 • **JOURNAL OF MATERIALS SCIENCE LETTERS, Band 7, Nr. 10, Oktober 1988, London (GB); Seiten 1090-1091; K. Umakantham et al.: "Influence of rare, earth ions on piezoelectric properties of modified PbTi03 ceramics".**

**Beschreibung**

Die Erfindung betrifft pyroelektrisches Keramikmaterial auf der Basis von Bleititanat sowie die Verwendung dieses Materials für Pyrodetektoren für Infrarotstrahlung.

Pyroelektrische Detektoren für Infrarotstrahlung sind zum Aufspüren von bewegten warmen Objekten geeignet, die eine Wärmestrahlung im Wellenlängenbereich von 8 bis 12 µm emittieren, entsprechend einer Körpertemperatur von etwa 300 K. Typische Anwendungsbeispiele von Pyrodetektoren sind z.B. Warnanlagen oder der Ersatz von Lichtschranken.

Für Pyrodetektoren eignen sich Materialien, deren Polarisation sich möglichst stark mit der Temperatur ändert. Es sind z.B. Kristalle bekannt, die bei einer Temperaturänderung eine elektrische Aufladung bestimmter Kristallflächen zeigen. Pyroelektrische Kristalle bauen sich aus geordneten polaren Atomgruppen auf, die sich in ihrer Wirkung überlagern und zu einer Polarisation P des Kristalls führen. Die Grenzflächen des Kristalls tragen dadurch Polarisationsladungen. Wird die Temperatur des Kristalls geändert, ändern sich auch die Polarisationsladungen an den Kristallgrenzflächen, weil die Polarisation P temperaturabhängig ist. Diese zufolge Temperaturänderung entstandene Polarisationsladung wird Pyroelektrizität genannt. Die durch Temperaturänderung freigesetzten kleinen Ladungsmengen können nach entsprechender Verstärkung ein elektronisches Signal auslösen.

Die wichtigste Kenngröße für die Wirksamkeit pyroelektrischen Materials ist der Pyrokoeffizient, d.h. die Änderung der ferroelektrischen Polarisation pro Kelvin im gewünschten Temperaturbereich:

$$p = \partial P/\partial T \text{ (Einheit: } 10^{-4} \text{C/m}^2 \text{K).}$$

Die mit dem Pyroeffekt verbundene Ladungsänderung wird elektronisch als Spannungsänderung, gewöhnlich mit Hilfe eines Feldeffekt-Transistors, an der pyroelektrischen Schicht detektiert nach der Gleichung $U = Q/C$ , wobei U die Pyrospannung in Volt, Q die Ladung in Coulomb und die C die Kapazität der pyroelektrischen Schicht bedeuten.

Um möglichst hohe Pyrospannungen zu erzielen, muß die Kapazität C der pyroelektrischen Schicht so gering wie möglich sein, was bei einer gegebenen Schichtdicke d und einer gegebenen Fläche A der Keramik nur über eine möglichst kleine relative Dielektrizitätskonstante $\varepsilon_r$ des keramischen Materials zu erreichen ist gemäß folgender Gleichung:

$$C = \varepsilon_0 \text{ x } \varepsilon_r \text{ x A/d.}$$

Von weiterer Bedeutung für die Wirksamkeit einer pyroelektrischen Keramik ist der Effektivitätskoeffizient, der in der angelsächsischen Literatur häufig mit der sogenannten "figure of merit" ($F_M$) charakterisiert wird: $F_M \approx p/(\varepsilon_r \text{ x } C_p)$ , worin $C_p$ die Wärmekapazität bedeutet.

Da sich die Wärmekapazität bei keramischen Sinterkörpern ähnlicher Zusammensetzung nur wenig ändert, wird zur Beurteilung ähnlicher Materialien häufig auch einevereinfachte Formel für den Effektivitätskoeffizientenbenutzt:

$$F'_M \approx p/\varepsilon_r.$$

Keramik für Pyrodetektoren sollte, außer daß sie möglichst hohe Werte für $F'_M$ aufweist, im Hinblick auf eine Großserienfertigung dafür geeignet sein, als surface mounted device (SMD) verarbeitet zu werden. SMD-Bauteile werden zum Löten durch Lotschwallbäder gezogen und dabei kurzzeitig Temperaturen bis zu etwa 250°C ausgesetzt. Entsprechend hoch muß der Curiepunkt der eingesetzten Pyrokeramik sein, damit sie beim Löten nicht thermisch depolarisiert wird, d.h. sie sollte einen Curiepunkt $T_c$ haben, der höher als 250°C liegt.

Aus GB-PS 1 504 283 war es bekannt, Pyrodetektoren aus einem Material auf Basis von Bleizirkonattitanat (PZT) herzustellen, das mit Lanthan und Mangan dotiert ist. Für Pyrodetektoren ist dieses Material nicht vorteilhaft, da seine Werte für die relative Dielektrizitätskonstante mit $\varepsilon_r > 1700$ zu hoch sind. Darüberhinaus zeigt PZT auch kein optimales Polarisierungsverhalten. Pyroelektrische Bauelemente auf PZT-Basis altern stark und zeigen deshalb auch keine ausreichend hohe Stabilität der Polarisation P, woraus keine ausreichend hohe Reversibilität von P resultiert.

Aus Electronic Ceramics 16 (1985), Seiten 43 bis 55 war ein pyroelektrisches Keramikmaterial auf der Basis eines Mischkristalls von Bleititanat (PT) mit Calciumtitanat entsprechend der Formel $Pb_{0.8}Ca_{0.2}(Ti_{0.96}(Co_{0.5}W_{0.5})_{0.04})O_3$ bekannt.

Bei der Sinterung dieses Materials wird die sich bildende $Pb_2WO_5$-Korngrenzzweitphase als Sinterhilfsphase benutzt. Nachteilig bei dieser Zusammensetzung ist, daß sich Wolfram in der Zweitphase anreichert und Kobalt demzufolge in der Matrix. Da Kobalt ein Akzeptor ist, wird eine große Zahl von Sauerstoffleerstellen gebildet, die wegen ihrer hohen Beweglichkeit Ionenleitfähigkeit zur Folge haben. Ionenleitfähigkeit kann jedoch bei dünnen Schichten und höheren Temperaturen zu Degradation führen, was für die Funktion der Bauelemente unerwünscht ist.

Für die praktische Anwendung ist es außerdem wünschenswert, daß Pyrodetektoren eine gute Mikrophoniestabilität aufweisen. Dies wird erreicht, wenn das Verhältnis der elektromechanischen Kopplungsfaktoren $k_p/k_t$ möglichst klein ist, d.h. < 1, was mit den bekannten Materialien für Pyrodetektoren, z.B. auf Basis von PZT, nicht erreicht wird.

Der Erfindung liegt die Aufgabe zugrunde, ein pyroelektrisches Keramikmaterial zur Verfügung zu stellen, das im Hinblick auf die Anwendung des Materials nicht nur besonders geeignete Werte für den Pyrokoeffizienten p, für den Curiepunkt $T_c$, die relative Dielektrizitätskonstante $\varepsilon_r$ und den Verlustfaktor tan $\delta$ aufweist, sondern das darüberhinaus degradationsstabil ist und das eine gute Reversibilität der Polarisierung und Mikrophoniestabilität zeigt.

Diese Aufgabe wird erfindungsgemäß dadurch gelöst, daß daspyroelektrische Keramikmaterial einer Zusammensetzung entspricht gemäß der Formel

$Pb_{1-(x+0,5(x-y))}SE_x(Ti_{1-y}Mn_y)O_3$, worin SE mindestens ein Seltenerdmetall und $0\ 04 \leq x \leq 0,20$ und $0,01 \leq y \leq 0,04$ sind.

Nach einer vorteilhaften Weiterbildung der Erfindung werden als Seltenerdmetall La, Sm und/oder Gd eingesetzt.

Bei den Arbeiten, die zur vorliegenden Erfindung geführt haben, wurde überraschenderweise gefunden, daß ein pyroelektrisch sehr wirksames Keramikmaterial erhalten werden kann, wenn einphasiges Material in Form von Bleititanat eingesetzt wird, das mit mindestens einem Seltenerdmetall, vorzugsweise La,Sm und/oder Gd, und mit Mangan dotiert wird. Die Mangandotierung, vorzugsweise mit einer Menge von 2 At.% substitutiv auf Ti-Plätzen, ist optimal für die Minimierung von $\varepsilon_r$.

Mit den erfindungsgemäßen Zusammensetzungen sind die weiteren Vorteile, die sich insbesondere für eine Großserienfertigung von Pyrodetektoren als günstig erweisen, verbunden, daß die keramischen Formkörper bruchfrei gesintert werden können und aufgrund ihres relativ hohen Curiepunktes besonders gut für eine SMD-Weiterverarbeitung geeignet sind. Die relativ niedrigen Werte für die relative Dielektrizitätskonstante $\varepsilon_r$ führen bei den erfindungsgemäßen Zusammensetzungen zu besonders günstigen Effektivitätskoeffizienten $F'_M$. Ein weiterer Vorteil ist, daß Pyrodetektoren auf Basis des erfindungsgemäßen Materials eine gute Mikrophoniestabilität aufweisen. Das Verhältnis der elektromechanischen Kopplungsfaktoren $k_p/k_t$ liegt in der Größenordnung von < 0,2 für $PL_8M_2$ und < 0,1 für $PS_8M_2$ (Formeln gemäß Tabelle 1).

$k_p$ bedeutet "planarer" Kopplungsfaktor und entspricht dem in der Literatur auch verwendeten Kopplungsfaktor $k_{31}$; $k_t$ bedeutet "thickness" Kopplungsfaktor und entspricht dem in der Literatur auch verwendeten Kopplungsfaktor $k_{33}$. Einer Messung sind $k_p$ und $k_t$ am einfachsten zugänglich, deshalb erfolgen Angaben in der Literatur meistens auf diese Weise.

Es sind bereits piezoelektrische Keramikmaterialien auf der Basis von Bleititanat bekannt, die mit Seltenenerdmetallen und Mangan dotiert sind. Beispielsweise wird in IEEE Transactions on Ultrasonics, Ferroelectrics and Frequency Control, 36 no. 4 (1989) 389-392, Kim et al. die Temperaturabhängigkeit der dielektrischen und piezoelektrischen Eigenschaften von mit Samarium und Mangan dotiertem Bleititanat der Zusammensetzung $Pb_{0,85}Sm_{0,10}(Ti_{0,98}Mn_{0,02})O_3$ untersucht. In American Ceramic Society Bulletin, 66 no.4 (1987) 699-703, Damjanovic wird die Anisotropie der piezoelektrischen Eigenschaften von modifizierten Bleititanatkeramiken, beispielsweise $Pb_{0,85}Sm_{0,10}(Ti_{0,98}Mn_{0,02})O_3$ beschrieben. Journal of Materials Science Letters 10 (1991) 917-919, Duran et al.,befaßt sich mit dem Einfluß von MnO-Zusätzen auf die Sinter- und piezoelektrischen Eigenschaften von samariumdotierten Bleititanatkeramiken der Zusammensetzung $(Pb_{0,88}Sm_{0,08})(Ti_{1-x}Mn_x)O_3$ mit $0 < x < 0.02$. Journal of Materials Science 23 (1988) 4463-4469, Duran et al., beschreibt die große elektromechanische Anisotropie von modifizierter Bleititanatkeramik, die mit Calcium, Lanthan, Neodym, Samarium oder Gadolinium sowie Cobalt und Wolfram oder Mangan dotiert ist. Für keine der in diesen vier Schriften erwähnten Keramiken werden pyroelektrische Eigenschaften erwähnt.

Anhand von Ausführungsbeispielen wird die Erfindung beschrieben und in ihrer Wirkungsweise erläutert.

Im Rahmen der Erfindung wurden pyroelektrische Keramikkörper der folgenden Zusammensetzungen hergestellt und zu Pyrodetektoren weiterverarbeitet:

Tabelle 1

| Probe | Zusammensetzung |
|---|---|
| $PL_4M_2$ | $Pb_{0,95}La_{0,04}Ti_{0,98}Mn_{0,02}O_3$ |
| $PL_6M_1$ | $Pb_{0,915}La_{0,06}Ti_{0,98}Mn_{0,01}O_3$ |
| $PL_6M_2$ | $Pb_{0,92}La_{0,06}Ti_{0,98}Mn_{0,02}O_3$ |
| $PL_6M_3$ | $Pb_{0,925}La_{0,06}Ti_{0,97}Mn_{0,03}O_3$ |
| $PL_6M_4$ | $Pb_{0,93}La_{0,06}Ti_{0,96}Mn_{0,04}O_3$ |
| $PL_8M_2$ | $Pb_{0,89}La_{0,08}Ti_{0,98}Mn_{0,02}O_3$ |
| $PS_8M_2$ | $Pb_{0,89}Sm_{0,08}Ti_{0,98}Mn_{0,02}O_3$ |
| $PS_{12}M_2$ | $Pb_{0,83}Sm_{0,12}Ti_{0,98}Mn_{0,02}O_3$ |
| $PS_{15}M_2$ | $Pb_{0,785}Sm_{0,15}Ti_{0,98}Mn_{0,02}O_3$ |
| $PG_{10}M_2$ | $Pb_{0,86}Gd_{0,10}Ti_{0,98}Mn_{0,02}O_3$. |

Die Proben wurden wie folgt hergestellt:

Bleioxid (PbO), Titanoxid ($TiO_2$), Manganoxid ($Mn_2O_3$) und die Oxide der entsprechenden Seltenerdmetalle (SE), alle von analysenreiner Qualität, wurden in entsprechender Menge eingewogen und in einer Achatkugelmühle in alkoholischer Suspension, vorzugsweise in Isopropanol, miteinander vermischt. Die Mischungen wurden anschließend nach dem Trocknen bei Temperaturen im Bereich von 900 bis 1100°C über eine Dauer von 10 h an Luft calciniert. Vorzugsweise wurde eine Calcinierung in 2 Stufen durchgeführt: 8 h bei einer Temperatur von 800°C und anschließend über eine Dauer von 10 h bei einer Temperatur von 950°C.

Nach dem Calcinieren werden die Pulver erneut in einer Achatkugelmühle in Isopropanol mehrere Stunden bis zu einem sinterfähigen Zustand gemahlen. Die Pulver wurden zunächst mechanisch bei einem Druck von etwa 0,5 kbar zu prismatischen Barren verpreßt und anschließend kalt isostatisch bei einem Druck von 3,5 kbar nachverdichtet.

Die gepreßten Barren wurden anschließend bei Temperaturen von 1260°C in lose geschlossenen Platintiegeln in einer $O_2$-Atmosphäre über eine Dauer von 4 h gesintert. Die typischen Dichten der Keramikkörper lagen bei etwa 97 bis 98% der theoretisch berechneten Dichte. Die gesinterten Barren wurden rund geschliffen auf einen Durchmesser von 5 mm und dann in Scheiben von 0,1 und 0,3 mm Dicke zersägt und geläppt. Für die elektrischen Messungen wurden die Scheiben mit Cr/Ni-Au-Elektroden bedampft.

Zur Polarisierung wurden die mit Elektroden versehenen Keramikscheiben in einem Ölbad bei einer Temperatur von 150°C unter Einwirkung eines Feldes von 70 kV/cm über eine Dauer von 5 min getempert und anschließend unter Feldeinwirkung langsam abgekühlt. Die Messung der Dielektrizitätskonstanten $\varepsilon_r$ wurde bei 1 kHz in einer handelsüblichen Meßbrücke durchgeführt.

Als Ausführungsbeispiel wird die Herstellung der Probe der Zusammensetzung $PS_{12}M_2$ angegeben:

Die präparierte Pulvermenge bezieht sich auf einen 1/3-molaren Ansatz.

64,353 g PbO, 5,812 g $Sm_2O_3$, 26,101 g $TiO_2$ und 0,5263 g $Mn_2O_3$ werden in einer Achatkugelmühle in Isopropanol gemischt.

Nach dem Mischen wird der Schlicker bei einer Temperatur von 80 bis 100°C getrocknet und in einem lose verschlossenen Tiegel aus Aluminiumoxid an Luft calciniert. Die Calcinierung verläuft in zwei Temperaturstufen: über eine Dauer von 8 h bei einer Temperatur von 800°C und anschließend über eine Dauer von 10 h bei einer Temperatur von 950°C.

Das calcinierte Produkt wird in einer Achatkugelmühle in Isopropanol aufgemahlen. Der Schlicker wird anschließend bei einer Temperatur von 80 bis 100°C getrocknet und in einem Mörser zu einem lockeren Pulver deaggregiert.

Das Pulver wird in einer Handspindelpresse bei einem uniaxialen Druck von etwa 500 bar zu prismatischen Blöcken einer Abmessung von 7x7x17 mm verpreßt. Anschließend werden die Preßkörper bei einem Druck von 3,5 kbar = 0,35 MPa kalt isostatisch nachverdichtet. Die grüne Dichte beträgt dann etwa 60% der theoretischen Dichte.

Die gepreßten prismatischen Blöcke werden in lose verschlossenen Platintiegeln über eine Dauer von 4 h bei einer Temperatur von 1260°C in strömender Sauerstoffatmosphäre gesintert.

Die gesinterten Blöcke werden auf einen Durchmesser von 5 mm rund geschliffen, in Scheiben gesägt und auf eine Dicke von 150 μm geläppt. Über eine dünne Haftschicht von Cr/Ni werden Goldelektroden in einer Dicke von 70 nm aufgedampft.

Die Polarisierung der Proben erfolgt über eine Dauer von 5 min in einem Ölbad bei einer Temperatur von 150°C und einer Feldstärke von $7 \times 10^6$ V/m. Die Proben werden unter Feldeinwirkung abgekühlt.

Die Polarisation wurde durch Erwärmen der Proben und integrale Ladungsmessung mit Hilfe eines handelsüblichen Elektrometers bestimmt. Die Ergebnisse dieser Messungen zeigt die nachfolgende Tabelle 2:

Tabelle 2

| Elektrische Eigenschaften | | | | | | |
|---|---|---|---|---|---|---|
| Probe | $\varepsilon r$ | p ($10^{-4}$C/m$^2$K) | p/$\varepsilon_r$ ($10^{-6}$C/m$^2$K) | $T_c$ (°C) | $\rho d_c$ ($10^8 \Omega . m$) | $E_c$ (kV/cm) |
| $PL_4M_2$ | 200 | 2,0 | 1,0 | > 350 | 1,5 | ≈ 50 |
| $PL_6M_1$ | 231 | 2,2 | 0,95 | > 350 | 1,5 | ≈ 50 |
| $PL_6M_2$ | 209 | 2,2 | 1,05 | > 350 | 1,5 | ≈ 50 |
| $PL_6M_3$ | 203 | 2,2 | 1,08 | > 350 | 1,5 | ≈ 60 |
| $PL_6M_4$ | 193 | 2,2 | 1,1 | > 350 | 1,5 | ≈ 70 |
| $PL_8M_2$ | 220 | 2,35 | 1,07 | 338 | 1,5 | ≈ 50 |
| $PS_8M_2$ | 173 | 2,35 | 1,35 | 335 | 0,7 | ≈ 50 |
| $PS_{12}M_2$ | 246 | 4,15 | 1,69 | 282 | 1,1 | ≈ 29 |
| $PS_{15}M_2$ | 306 | 4,70 | 1,54 | 213 | 3,6 | ≈ 33 |
| $PG_{10}M_2$ | 205 | 3,35 | 1,64 | 318 | 0,8 | ≈ 35 |

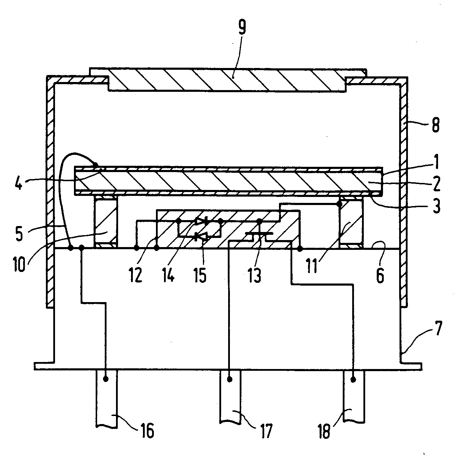

**Patentansprüche**

1. Pyroelektrisches Keramikmaterial auf der Basis von Bleititanat,
   dadurch gekennzeichnet,
   daß es einer Zusammensetzung entspricht gemäß der Formel $Pb_{1-(x+0,5(x-y))}SE_x(Ti_{1-y}Mn_y)O_3$, worin SE mindestens ein Seltenerdmetall und $0,04 \leq x \leq 0,20$ und $0,01 \leq y \leq 0,04$ sind.

2. Pyroelektrisches Keramikmaterial nach Anspruch 1,
   dadurch gekennzeichnet,
   daß als Seltenerdmetall La, Sm und/oder Gd eingesetzt werden.

3. Pyroelektrisches Keramikmaterial nach den Ansprüchen 1 und 2,
   dadurch gekennzeichnet,
   daß y = 0,02 ist.

4. Pyroelektrisches Keramikmaterial nach mindestens einem der Ansprüche 1 bis 3,
   dadurch gekennzeichnet,
   daß es einer Zusammensetzung entspricht gemäß der Formel

$$Pb_{1-(x+0,5(x-0,02))}La_xTi_{0,98}Mn_{0,02}O_3$$

   mit $0,04 \leq x \leq 0,08$.

5. Pyroelektrisches Keramikmaterial nach mindestens einem der Ansprüche 1 bis 3,
   dadurch gekennzeichnet,
   daß es einer Zusammensetzung entspricht gemäß der Formel

$$Pb_{1-(x+0,5(x-0,02))}Sm_xTi_{0,98}Mn_{0,02}O_3$$

   mit $0,08 \leq x \leq 0,15$.

6. Pyroelektrisches Keramikmaterial nach mindestens einem der Ansprüche 1 bis 3,
   <u>dadurch gekennzeichnet,</u>
   daß es einer Zusammensetzung entspricht gemäß der Formel

$$Pb_{0,86}Gd_{0,10}Ti_{0,98}Mn_{0,02}O_3.$$

7. Verwendung des pyroelektrischen Keramikmaterials nach den Ansprüchen 1 bis 6 zur Herstellung von pyroelektrischen Detektoren für Infrarotstrahlung.

**Claims**

1. Pyroelectric ceramic material on the basis of lead titanate, characterized in that the composition thereof corresponds to the formula

$$Pb_{1-(x+0.5(x-y))}RE_xTi_{1-y}Mn_yO_3,$$

   where RE is at least one rare earth metal and $0.04 \leq x \leq 0.20$ and $0.01 \leq y \leq 0.04$.

2. Pyroelectric ceramic material as claimed in Claim 1, characterized in that La, Sm and/or Gd are used as the rare earth metals.

3. Pyroelectric ceramic material as claimed in Claims 1 and 2, characterized in that $y = 0.02$.

4. Pyroelectric ceramic material as claimed in at least one of the Claims 1 to 3, characterized in that the composition thereof corresponds to the formula

$$Pb_{1-(x+0.5(x-0.02))}La_xTi_{0.98}Mn_{0.02}O_3,$$

   where $0.04 \leq x \leq 0.08$.

5. Pyroelectric ceramic material as claimed in at least one of the Claims 1 to 3, characterized in that the composition thereof corresponds to the formula

$$Pb_{1-(x+0.5(x-0.02))}Sm_xTi_{0.98}Mn_{0.02}O_3,$$

   where $0.08 \leq x \leq 0.15$.

6. Pyroelectric ceramic material as claimed in at least one of the Claims 1 to 3, characterized in that the composition thereof corresponds to the formula

$$Pb_{0.86}Gd_{0.10}Ti_{0.98}Mn_{0.02}O_3.$$

7. The use of the pyroelectric ceramic material as claimed in Claims 1 to 6 for the manufacture of pyroelectric detectors for infrared radiation.

**Revendications**

1. Matériau céramique pyroélectrique à base de titanate de plomb, caractérisé en ce qu'il correspond à une composition selon la formule :

$$Pb_{1-(x+0,5(x-y))}TR_x(Ti_{1-y}Mn_y)O_3,$$

   dans laquelle TR est au moins un métal des terres rares et $0,04 \leq x \leq 0,20$ et $0,01 \leq y \leq 0,04$.

2. Matériau céramique pyroélectrique selon la revendication 1, caractérisé en ce que La, Sm et/ou Gd sont utilisés comme métal des terres rares.

3. Matériau céramique pyroélectrique selon les revendications 1 et 2, caractérisé en ce que $y = 0,02$.

4. Matériau céramique pyroélectrique selon au moins l'une des revendications 1 à 3, caractérisé en ce qu'il correspond à une composition selon la formule :

$$Pb_{1-(x+0,5(x-0,02))}La_xTi_{0,98}Mn_{0,02}O_3$$

avec $0,04 \leq x \leq 0,08$.

5. Matériau céramique pyroélectrique selon au moins l'une des revendications 1 à 3, caractérisé en ce qu'il correspond à une composition selon la formule :

$$Pb_{1-(x+0,5(x-0,02))}Sm_xTi_{0,98}Mn_{0,02}O_3$$

avec $0,08 \leq x \leq 0,15$.

6. Matériau céramique pyroélectrique selon au moins l'une des revendications 1 à 3, caractérisé en ce qu'il correspond à une composition selon la formule :

$$Pb_{0,86}Gd_{0,10}Ti_{0,98}Mn_{0,02}O_3$$

7. Utilisation du matériau céramique pyroélectrique selon les revendications 1 à 6 pour la fabrication de détecteurs pyroélectriques de rayons infrarouges.